(19) Europäisches Patentamt

European Patent Office

Office européen des brevets

(11) **EP 4 299 661 A1**

(12) **EUROPEAN PATENT APPLICATION**
published in accordance with Art. 153(4) EPC

(43) Date of publication:
**03.01.2024 Bulletin 2024/01**

(21) Application number: **22759651.7**

(22) Date of filing: **22.02.2022**

(51) International Patent Classification (IPC):
*C08K 7/00* (2006.01)       *C08L 23/12* (2006.01)
*C08L 77/00* (2006.01)       *C08L 101/00* (2006.01)
*C09K 5/14* (2006.01)        *C08K 3/08* (2006.01)

(52) Cooperative Patent Classification (CPC):
**C08K 3/08; C08K 7/00; C08L 23/12; C08L 77/00;
C08L 101/00; C09K 5/14**

(86) International application number:
**PCT/JP2022/007255**

(87) International publication number:
**WO 2022/181615 (01.09.2022 Gazette 2022/35)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **25.02.2021   JP 2021028952**

(71) Applicant: **Mitsui Chemicals, Inc.
Tokyo 104-0028 (JP)**

(72) Inventors:
• **HE, Jiacheng**
  **Sodegaura-shi, Chiba 299-0265 (JP)**
• **YOSHII, Hiroaki**
  **Sodegaura-shi, Chiba 299-0265 (JP)**
• **TANAKA, Hirokazu**
  **Sodegaura-shi, Chiba 299-0265 (JP)**

(74) Representative: **J A Kemp LLP
80 Turnmill Street
London EC1M 5QU (GB)**

(54) **ELECTROMAGNETIC-WAVE ABSORBING AND THERMALLY CONDUCTIVE MATERIAL, AND ELECTROMAGNETIC-WAVE ABSORBING AND THERMALLY CONDUCTIVE HOUSING**

(57)     Provided is an electromagnetic wave absorbing thermally conductive material which contains a thermoplastic resin, a high-magnetic-permeability metal, and carbon nanotubes.

EP 4 299 661 A1

**Description**

Technical Field

The present invention relates to: an electromagnetic wave absorbing thermally conductive material; and an electromagnetic wave absorbing thermally conductive housing.

Background Art

In recent years, electric vehicles (EVs) have been actively developed. Electric vehicles are equipped with an electric motor generating a driving force, and a secondary battery as a driving power source. There is a trend that the amount of electric current supplied to the electric motor from the secondary battery is increasing more and more. In association with this, the development of high-speed power supply by a conductive method using a cable, as well as the development of contactless power supply method are being rapidly advanced.

On the other hand, for example, charging and discharging of a secondary battery may cause unintentional emission of electromagnetic waves in a low-frequency band (i.e. from 10 kHz to 500 kHz) (such electromagnetic waves are hereinafter also referred to as "radiation noise") from the secondary battery and the like that do not naturally generate electromagnetic waves. Such radiation noise poses a risk of interfering with the normal operation of electronic devices. Therefore, various regulations (e.g., CISPR22, CISPR25, and IEC61980) have been implemented.

Patent Document 1 discloses composites suitable for use as electromagnetic interference mitigators. The composites disclosed in Patent Document 1 contain a lossy polymeric matrix, ceramic particles, and conductive particles. The ceramic particles are dispersed in the lossy polymer matrix. The conductive particles are also dispersed in the lossy polymer matrix.

Patent Document 2 discloses a magnetic sheet. In the magnetic sheet disclosed in Patent Document 2, a thin sheet-shaped magnetic body formed of an Fe-based metal magnetic material is maintained on a resin film via an adhesive layer. The thin sheet-shaped magnetic body has a single-layer thickness of from 15 $\mu$m to 35 $\mu$m. The thin sheet-shaped magnetic body has an alternating-current relative magnetic permeability $\mu$r of from 200 to 770 at a frequency of 500 kHz.

Patent Document 1: Japanese Patent Application Laid-Open (JP-A) No. 2019-143149
Patent Document 2: WO 2014/157526

SUMMARY OF THE INVENTION

Technical Problem

The driving range of an electric vehicle may be shorter than that of a gasoline vehicle. Thus, in order to extend the driving range of electric vehicles, electric vehicles have been increasingly reduced in weight. Specifically, studies have been conducted on switching from a conventional metal housing to a resin housing. A resin housing, however, tends to have a lower mechanical strength than a metal housing. In addition, the above-described electromagnetic waves are likely to pass through a resin housing. Therefore, a conventional resin housing may fail to conform to the above-described regulations.

Further, in recent years, electric vehicles are increasingly equipped with technologies (e.g., an external recognition system) supporting ADAS (Advanced Driver-Assistance System) as a key technology for autonomous driving. In an exterior recognition system, a radar device for ultrahigh-frequency electromagnetic waves (e.g., from 76 GHz to 78 GHz) is used in many cases. The radar device emits ultrahigh-frequency electromagnetic waves from a transmitting antenna and receives the ultrahigh-frequency electromagnetic waves reflected from an obstacle using a receiving antenna to detect the position, relative speed, direction and the like of the obstacle. A metal housing may completely reflect the ultrahigh-frequency electromagnetic waves emitted from the transmitting antenna. As a result, when an electric vehicle is equipped with a metal housing (e.g., an inverter, an emblem, an electronic control unit, or an EV battery), the radar device may not be able to accurately detect the position and the like of an obstacle.

Therefore, there is a strong demand for the development of a material alternative to metallic materials, which material has both a function of shielding electromagnetic waves in a low-frequency band (e.g., from 10 kHz to 100 kHz) (a function mainly required for electric vehicles) and a function of absorbing electromagnetic waves in a high-frequency band (e.g., from 76 GHz to 78 GHz) (a function mainly required for autonomous driving).

The composite laminated body disclosed in Patent Document 1 shields electromagnetic waves in a low-frequency band; however, it may not be able to sufficiently absorb electromagnetic waves in a high-frequency band.

The magnetic sheet disclosed in Patent Document 2 may reflect electromagnetic waves in a high-frequency band (e.g., 76 GHz). The resin film does not affect electromagnetic waves. In other words, electromagnetic waves pass through the resin film. Although the thin sheet-shaped magnetic body absorbs electromagnetic waves in a low-frequency band to a certain extent, it reflects electromagnetic waves in a high-frequency band. The reason why the thin sheet-shaped magnetic body reflects electromagnetic waves in a high-frequency band is presumed to be because the material of the thin sheet-shaped magnetic body is a metal, and the thin sheet-shaped magnetic body thus has a low surface resistance.

Meanwhile, an increase in the clock frequency of a semiconductor element may lead to the generation of radiation noise. At the same time, the amount of heat generated by the semiconductor element is increased, and there is thus a need for a measure against heat dissipation inside electronic devices. In addition, with size reduction and increased integration of semiconductor elements, the volume of the internal space of electronic devices has been decreased. Therefore, for example, a material which is, in the form of a single sheet, capable of providing measures against radiation noise and heat dissipation of a semiconductor element is demanded.

An object of one aspect of the present disclosure is to provide an electromagnetic wave absorbing thermally conductive material and an electromagnetic wave absorbing thermally conductive housing, which not only shield electromagnetic waves in a low-frequency band and absorb electromagnetic waves in a high-frequency band but also have a favorable thermal conductivity.

Solution to Problem

Means for solving the above-described problem include the following embodiments.

<1> An electromagnetic wave absorbing thermally conductive material, containing:

a thermoplastic resin;
a high-magnetic-permeability metal; and
carbon nanotubes.

<2> The electromagnetic wave absorbing thermally conductive material according to <1>, wherein the high-magnetic-permeability metal contains a nanocrystalline soft magnetic alloy.

<3> The electromagnetic wave absorbing thermally conductive material according to <2>, wherein the nanocrystalline soft magnetic alloy contains an FeBSi-based nanocrystalline soft magnetic alloy containing Fe, B, and Si.

<4> The electromagnetic wave absorbing thermally conductive material according to <1>, wherein the high-magnetic-permeability metal contains at least one of an FeNi-based soft magnetic alloy containing Fe and Ni, or an FeBSi-based nanocrystalline soft magnetic alloy containing Fe, B, and Si.

<5> The electromagnetic wave absorbing thermally conductive material according to any one of <1> to <4>, wherein the thermoplastic resin contains at least one selected from the group consisting of polypropylenes, polyethylenes, polyesters, and polyamides.

<6> The electromagnetic wave absorbing thermally conductive material according to any one of <1> to <5>, wherein the carbon nanotubes contain at least one of multi-walled carbon nanotubes or single-walled carbon nanotubes.

<7> The electromagnetic wave absorbing thermally conductive material according to any one of <1> to <6>, further containing a carbon material.

<8> The electromagnetic wave absorbing thermally conductive material according to any one of <1> to <7>, containing:

a magnetic loss layer containing the high-magnetic-permeability metal; and
a dielectric loss layer laminated on at least one main surface of the magnetic loss layer,
wherein the dielectric loss layer contains the thermoplastic resin and the carbon nanotubes.

<9> The electromagnetic wave absorbing thermally conductive material according to <8>, wherein the dielectric loss layer has a thickness of from 0.01 mm to 30 mm.

<10> The electromagnetic wave absorbing thermally conductive material according to <8> or <9>, wherein a content of the carbon nanotubes is from 0.5% by mass to 30% by mass with respect to a total amount of the dielectric loss layer.

<11> The electromagnetic wave absorbing thermally conductive material according to any one of <1> to <10>, which is a sheet-like product.

<12> The electromagnetic wave absorbing thermally conductive material according to any one of <1> to <11>, which is used for absorbing electromagnetic waves leaking from a contactless power supply apparatus that performs contactless power supply.

<13> An electromagnetic wave absorbing thermally conductive housing, including:

a housing of an electronic device, an electronic control unit, an unmanned aerial vehicle, or a lithium secondary battery; and
the electromagnetic wave absorbing thermally conductive material according to <11>, which is attached to an inside of the housing.

<14> An electromagnetic wave absorbing thermally conductive housing obtained by molding the electromagnetic wave absorbing thermally conductive material according to any one of <1> to <7>,
wherein the electromagnetic wave absorbing thermally conductive housing is used for housing an electronic device, an electronic control unit, an unmanned aerial vehicle, or a lithium secondary battery.

Advantageous Effects of Invention

According to one aspect of the disclosure, an electromagnetic wave absorbing thermally conductive material and an electromagnetic wave absorbing thermally conductive housing, which not only shield electromagnetic waves in a low-frequency band and absorb electromagnetic waves in a high-frequency band but also have a favorable thermal conductivity, are provided.

DESCRIPTION OF EMBODIMENTS

Mode for Carrying Out the Invention

In the disclosure, those numerical ranges that are expressed with "to" each denote a range that includes the numerical values stated before and after "to" as the minimum value and the maximum value, respectively.
In a set of numerical ranges that are stated in a stepwise manner in the disclosure, the upper limit value or the lower limit value of one numerical range may be replaced with the upper limit value or the lower limit value of other numerical range, or may be replaced with a relevant value indicated in any of Examples.
In the disclosure, when there are plural substances that correspond to a component of a material, the indicated amount of the component in the material means, unless otherwise specified, a total amount of the plural substances existing in the material.
In the disclosure, when an embodiment is described referring to a drawing, the constitution of the embodiment is not limited to the one illustrated in the drawing. The sizes of members in each drawing are conceptual, and the relative size relationships among members are not restricted to those illustrated in the drawings.
In the drawings, the same or corresponding parts are denoted by the same reference symbol, and description thereof is not repeated.

(1) Electromagnetic Wave Absorbing Thermally Conductive Material

The electromagnetic wave absorbing thermally conductive material of the disclosure contains: a thermoplastic resin; a high-magnetic-permeability metal; and carbon nanotubes.
The term "high-magnetic-permeability metal" used herein refers to a material having a high magnetic permeability, which instantaneously exhibits high magnetization even when a small magnetic field is applied thereto from the outside. The high-magnetic-permeability metal has a relative magnetic permeability ($\mu r$) of 5,000 or more.
Carbon nanotubes may be hereinafter referred to as "CNTs".
The electromagnetic wave absorbing thermally conductive material of the disclosure has the above-described constitution and is, therefore, capable of not only shielding electromagnetic waves in a low-frequency band but also absorbing electromagnetic waves in a high-frequency band. The low-frequency band includes frequencies of from 1 Hz to 1,000 kHz. The high-frequency band includes frequencies of from 1 GHz to 100 GHz. Further, the electromagnetic wave absorbing thermally conductive material of the disclosure can efficiently conduct heat.
In addition, the electromagnetic wave absorbing thermally conductive material of the disclosure can attenuate each of the electric field component and the magnetic field component of electromagnetic waves in a low-frequency band. In other words, the electromagnetic wave absorbing thermally conductive material of the disclosure can convert (absorb) the energy of each of the electric field component and the magnetic field component of electromagnetic waves in a low-frequency band into heat.
A design concept of a shielding material that absorbs electromagnetic waves in a high-frequency band while shielding electromagnetic waves in a low-frequency band is as follows.
When the shielding material is irradiated with electromagnetic waves, the electromagnetic waves entering the shielding material are separated into a reflected component and an introduced component. The reflected component refers to electromagnetic waves that are reflected by the shielding material and do not penetrate into the shielding material. The introduced component refers to electromagnetic waves that are introduced into the shielding material without being reflected by the shielding material. The introduced component passes through the shielding material with attenuation inside the shielding material.

Hereinafter, in the introduced component, electromagnetic waves attenuated inside the shielding material are referred to as "absorbed component", while electromagnetic waves passed through the shielding material are referred to as "transmitted component".

The shielding rate (%) is represented by the following equation (A):

$$\text{Equation (A): Shielding rate (\%)} = 100\ (\%) - \text{Transmittance (\%)} = 100 - [(\text{Intensity of transmitted component/Intensity of incident component}) \times 100]$$

The intensity of shielded electromagnetic waves is a total of the intensity of the reflected component and the intensity of the absorbed component.

In the equation (A), "Intensity of incident component" refers to a total of the intensity of the reflected component, the intensity of the absorbed component, and the intensity of the transmitted component.

When it is desired to allow the shielding material to absorb electromagnetic waves in a high-frequency band without reflection, a first method and a second method are preferably employed.

In the first method, in order to reduce the reflected component, the surface of the shielding material is desired to have an electrical conductivity (impedance) approximately equal to that of the atmosphere. As a material of the surface of the shielding material, a metal is not suitable.

In the second method, in order to improve the intensity of the absorbed component, it is preferred to use, as a material of the shielding material, a material having a high dielectric loss, a high permittivity, a high magnetic loss, and a high magnetic permeability. In other words, a material which reduces the surface electrical conductivity of the shielding material for electromagnetic waves in a high-frequency band to allow the electromagnetic waves to be introduced into the shielding material, and absorbs the electromagnetic waves through attenuation inside the shielding material (i.e. converts the energy of the electromagnetic waves into heat) is preferred.

Meanwhile, when it is desired to allow the shielding material to shield electromagnetic waves in a low-frequency band, a third method or a fourth method is preferably employed.

In the third method, as a material of the surface of the shielding material, a material having an extremely high electrical conductivity like a metal is used to allow the surface of the shielding material to reflect the electromagnetic waves.

In the fourth method, as a material of the shielding material, a material having a high permittivity, a high dielectric loss, a high magnetic permeability, and a high magnetic loss is used. However, in the fourth method, the absorption effect term indicating the intensity of the absorbed component is generally represented as a product with the frequency of the electromagnetic waves. Therefore, with regard to electromagnetic waves in a low-frequency band, an improvement in the intensity of the absorbed component cannot be overly expected. In other words, as a material of the shielding material, a material which increases the surface electrical conductivity of the shielding material for electromagnetic waves in a low-frequency band to reflect the electromagnetic waves, and absorbs the electromagnetic waves through magnetic loss and dielectric induction inside the shielding material is preferred.

Specifically, a non-metallic dielectric loss material or magnetic loss material used as a surface layer of the shielding material is combined with a reflective metal laminated body (preferably a magnetic metal or an amorphous nanometal which exhibits a favorable magnetic loss) used as an inner layer of the shielding material. As a result, the surface layer of the shielding material assumes a role in absorption of electromagnetic waves in a high-frequency band, while the inner layer of the shielding material assumes a role in shielding (reflection + absorption) of electromagnetic waves in a low-frequency band. The reason for using a magnetic material (e.g., an Fe-Ni-based soft magnetic metal, more preferably an amorphous nanocrystalline metal) as the inner layer is because such a metal exhibits an extremely large magnetic loss in a low-frequency band and is thus expected to absorb the magnetic component of the electromagnetic waves.

In addition, by disposing the surface layer and the inner layer on one another and thereby creating an interface between the surface layer and the inner layer, multiple reflections are made more likely to occur at the interface due to a difference in electrical conductivity, so that an improvement in the intensity of the absorbed component can be expected as well.

(1.1) Thermoplastic Resin

The electromagnetic wave absorbing thermally conductive material contains a thermoplastic resin.

Examples of the thermoplastic resin include polypropylenes, polyamides, polyethylenes, hydrogenated styrene-based thermoplastic elastomers (SEBS), ethylenepropylene copolymers, ethylene-butene copolymers, propylene-butene copolymers, ethylene-methacrylic acid copolymers, ethylene-acrylic acid copolymers, ethylene-vinyl acetate copolymers, ethylene-ethyl acrylate copolymers, ionomer resins, polybutenes, 4-methylpentene-1 resins, cyclic polyolefin-based resins, ethylene-styrene copolymers, styrene-based resins, styrene-ethylene-butylene-styrene block copolymers, polyvinyl chlorides, polyvinylidene chlorides, polycarbonates, polyacetals, polyphenylene oxides, polyvinyl acetates, polyvinyl alcohols, polymethyl methacrylates, cellulose acetate, polyesters, polyimides, fluorine resins, polysulfones, polyether sulfones, polyarylates, polyether ether ketones, liquid-crystal polymers, thermoplastic polyurethanes, thermoplastic elastomers, and biodegradable polymers. These resins may be used singly, or in combination of two or more kinds thereof.

The polypropylenes include homopolypropylenes, random polypropylene copolymers, block polypropylene copolymers, and ultrahigh-molecular-weight polypropylenes.

The polyethylenes include low-density polyethylenes, high-density polyethylenes, medium-density polyethylenes, linear low-density polyethylenes, and ultrahigh-molecular-weight polyethylenes.

The ionomer resins include ethylene-methacrylic acid copolymer ionomer resins.

The styrene-based resins include polystyrenes, butadiene-styrene copolymers (HIPS), acrylonitrile-styrene copolymers (AS resins), and acrylonitrile-butadiene-styrene copolymers (ABS resins).

The polyesters include polyethylene terephthalate, polybutylene terephthalate, and polytrimethylene terephthalate.

The biodegradable polymers include hydroxycarboxylic acid condensates such as polylactic acid, and condensates of a diol and a carboxylic acid, such as polybutylene succinate.

Thereamong, the thermoplastic resin preferably contains at least one selected from the group consisting of polypropylenes, polyethylenes, polyesters, and polyamides. This enables to appropriately disperse the CNTs while relatively maintaining the mechanical strength and the heat resistance of the electromagnetic wave absorbing thermally conductive material even at a low cost.

From the standpoint of mechanical strength, heat resistance, and moldability, a content of the thermoplastic resin is preferably from 65.0% by mass to 99.5% by mass, more preferably from 70.0% by mass to 99.5% by mass, still more preferably from 80.0% by mass to 99.5% by mass, with respect to a total amount of the electromagnetic wave absorbing thermally conductive material.

(1.2) Carbon Nanotubes

The electromagnetic wave absorbing thermally conductive material contains CNTs.

The CNTs have a shape in which a graphene sheet is rolled in a single-layer or multi-layer cylindrical form.

The CNTs preferably contain at least one of multi-walled CNTs or single-walled CNTs, and more preferably contain multi-walled CNTs. When the CNTs contain at least one of single-walled CNTs or multi-walled CNTs, the dielectric loss and the electrical conductivity of the electromagnetic wave absorbing thermally conductive material can be improved even with a small amount of the CNTs.

When the CNTs contain multi-walled CNTs, a resin composite material having a lower viscosity than that of single-walled CNTs is obtained, so that the production process of the electromagnetic wave absorbing thermally conductive material can be simplified. In addition, multi-walled CNTs are superior to single-walled CNTs in terms of cost. Further, multi-walled CNTs take a capacitor-like structure, and are thus presumed to be advantageous for the loss of electromagnetic waves.

The CNTs have an average diameter of preferably from 7 nm to 50 nm, more preferably from 10 nm to 50 nm, still more preferably from 20 nm to 40 nm. As long as the average diameter of the CNTs is in this range, aggregation of the CNTs in the thermoplastic resin can be effectively inhibited.

The CNTs have an average length of preferably from 1,000 nm to 10,000 nm, more preferably from 2,000 nm to 5,000 nm. As long as the average length of the CNTs is in this range, aggregation of the CNTs in the thermoplastic resin can be effectively inhibited.

The average diameter and the average length of the CNTs are each determined as an arithmetic mean of the diameter and the length, respectively, of randomly extracted plural (n = 10) CNTs measured by, for example, observation under an electron microscope.

A content of the CNTs is preferably from 0.5% by mass to 30% by mass, more preferably from 3% by mass to 25% by mass, still more preferably from 5% by mass to 20% by mass, with respect to a total amount of the electromagnetic wave absorbing thermally conductive material.

The CNTs may be a commercially available product. Examples thereof include "NC7000" manufactured by Nanocyl SA, and "FLOTUBE 9000" manufactured by Cnano Technology Co., Ltd.

(1.3) High-Magnetic-Permeability Metal

The electromagnetic wave absorbing thermally conductive material contains a high-magnetic-permeability metal.

Examples of the high-magnetic-permeability metal include Fe-Ni-based soft magnetic metals, nanocrystalline soft magnetic alloys, invar (Fe-36Ni), supermalloy (Fe-79Ni-5Mo), and permendur (Fe-49Co-2V).

The high-magnetic-permeability metal preferably contains a nanocrystalline soft magnetic alloy. The nanocrystalline soft magnetic alloy exhibits a relatively high magnetic loss even in a low-frequency band due to its fine metal crystals. Therefore, by incorporating the nanocrystalline soft magnetic alloy into the high-magnetic-permeability metal, the electromagnetic wave shielding performance in a low-frequency band can be improved.

The high-magnetic-permeability metal preferably contains at least one of an FeNi-based soft magnetic alloy containing Fe and Ni, or an FeBSi-based nanocrystalline soft magnetic alloy containing Fe, B, and Si. The FeNi-based soft magnetic alloy or the FeBSi-based nanocrystalline soft magnetic alloy exhibits a relatively high magnetic loss even in a low-frequency band. Therefore, by incorporating at least one of the FeNi-based soft magnetic alloy or the FeBSi-based nanocrystalline soft magnetic alloy into the high-magnetic-permeability metal, the electromagnetic wave shielding performance in a low-frequency band can be improved.

(1.3.1) Nanocrystalline Soft Magnetic Alloy

The material of the nanocrystalline soft magnetic alloy preferably contains an Fe-Si-B-based nanocrystalline soft magnetic alloy containing Fe, Si, and B (hereinafter, simply referred to as "Fe-Si-B-based alloy").

The Fe-Si-B-based alloy contains an Fe-B-Si-C-based alloy, an Fe-Cu-Nb-Si-B-based alloy, an Fe-Cu-Nb-Si-B-P-based alloy, an Fe-Cu-Si-B-P-based alloy, an Fe-Cu-Si-B-based alloy, or an Fe-Cu-Mo-Si-B-based alloy. The Fe-Si-B-based alloy may also contain, as other metal elements, unavoidable impurities such as Mn, S, and P.

An Fe-B-Si-Cu-based alloy is represented by a general formula $F_{2100-a-b-c}B_aSi_bCu_c$, wherein a, b, and c are in % by atom and satisfy $7 \leq a \leq 20$, $1 \leq b \leq 19$, $0 \leq c \leq 4$, $75 \leq (100 - a - b - c) \leq 85$.

The Fe-Cu-Nb-Si-B-based alloy includes $Fe_{82}Cu_1Nb_1Si_4B_{12}$.

The Fe-Cu-Nb-Si-B-P-based alloy includes $Fe_{82}Cu_1Nb_1Si_2B_{12}P_2$.

The Fe-Cu-Si-B-P-based alloy includes $Fe_{80.8}Cu_{1.2}Si_5B_{11}P_2$.

The Fe-Cu-Si-B-based alloy includes $Fe_{80.5}Cu_{1.5}Si_4B_{14}$.

The Fe-Cu-Mo-Si-B-based alloy includes $Fe_{80.8}Cu_{1.0}Mo_{0.2}Si_4B_{14}$.

The nanocrystalline soft magnetic alloy is preferably one obtained by solidification of a high-temperature melt having a specific composition with rapid cooling at about 1,000,000°C/sec and subsequent crystallization of a portion of the resulting amorphous alloy by the below-described heat treatment. The "crystallization" refers to a treatment that causes crystals containing crystal grains of at least several hundred nanometers to one micrometer to crystallize. This crystallization is different from nanocrystallization. The "nanocrystallization" refers to a treatment that causes nano-scale crystal grains of 100 nm or smaller to crystallize in an amorphous matrix.

Particularly, the nanocrystalline soft magnetic alloy is preferably one produced in the following manner.

First, raw materials weighed to have a specific composition are melted. One example of a method of melting the raw materials is high-frequency induction melting.

The resulting molten product of the raw materials is made into an amorphous alloy ribbon by a rapid cooling method. One example of the rapid cooling method is a method using a single roll or a twin roll, in which the molten product is discharged via a nozzle onto the surface of a cooling roll rotating at a high speed and thereby rapidly cooled and solidified. The thickness of the amorphous alloy ribbon is preferably from 15 $\mu$m to 35 $\mu$m.

Cu does not have to be contained in the nanocrystalline soft magnetic alloy; however, from the standpoint of improving the wettability of the molten metal with the surface of the cooling roll, a content of Cu is preferably not less than 0.5% by atom with respect to a total amount of the nanocrystalline soft magnetic alloy, and it is more preferably 4% by atom or less depending on the thickness of the ribbon to be produced.

In order to crystallize at least a portion of the structure of the amorphous alloy, it is preferred to perform a heat treatment on the amorphous alloy. The heat treatment is performed at a temperature of, for example, higher than 430°C. In a heat treatment performed at a temperature of higher than a crystallization temperature Tk, a compound phase of $Fe_2B$ is precipitated, and this leads to a marked increase in the coercivity Hc. Therefore, the heat treatment is preferably performed at a temperature of lower than the crystallization temperature Tk under a condition in which a compound phase of $Fe_2B$ is hardly crystallized, or crystallized only in a small amount if any. Specifically, the heat treatment is more preferably performed at a temperature of (Tk - 60°C) or lower, which is sufficiently lower than the crystallization temperature Tk.

In the heat treatment, the retention time is also important along with the temperature. In order to allow $\alpha$-Fe to sufficiently form a solid solution with Si during the crystallization, the retention time is preferably 20 minutes or longer.

When the retention time is longer than 180 minutes, $Fe_2B$ may be crystallized. The retention time is thus preferably from 20 minutes to 180 minutes. Examples of a heat treatment atmosphere include an air atmosphere and an inert atmosphere and, from the standpoint of inhibiting the oxidation of the nanocrystalline soft magnetic alloy, the heat treatment atmosphere is preferably an inert atmosphere. An inert gas constituting the inert atmosphere is, for example, argon or nitrogen gas.

The nanocrystalline soft magnetic alloy may be a commercially available product. Examples of a commercially available product of the Fe-Cu-Nb-Si-B-based alloy include FINEMET (registered trademark) "FT-3M", "FT-3H", "FT-3L", and "FT-3S", which are manufactured by Hitachi Metals, Ltd.

(1.3.2) Fe-Ni-based Soft Magnetic Metal

The material of an Fe-Ni-based soft magnetic metal preferably contains an Fe-Ni-based soft magnetic alloy containing Fe and Ni (hereinafter, referred to as "Fe-Ni-based alloy"). The Fe-Ni-based alloy is represented by a general formula $Fe_{100-a}Ni_a$ and may also contain, as other metal elements, unavoidable impurities such as Mn, S, and P, as well as intentional additives such as Mo and Cu. In terms of magnetic permeability, a is desirably $48 \leq a \leq 81$.

The Fe-Ni-based alloy may be a commercially available product. Examples thereof include PERMALLOY (registered trademark) "MEMPC-1", "MEMPC-2", "MEMPC-2S", and "MEMPB-S", which are manufactured by Daido Steel Co., Ltd.

From the standpoint of magnetic wave absorbing performance and mechanical strength, a content of the high-magnetic-permeability metal is preferably from 0.5% by mass to 30% by mass, more preferably from 1% by mass to 20% by mass, with respect to a total amount of the electromagnetic wave absorbing thermally conductive material.

(1.4) Carbon Material

The electromagnetic wave absorbing thermally conductive material preferably further contains a carbon material. By this, even with a small amount of the carbon material, not only the dielectric loss and the electrical conductivity can be improved, but also the mechanical strength of the electromagnetic wave absorbing thermally conductive material can be improved.

The term "carbon material" used herein refers to any material containing carbon as a main component, excluding carbon nanotubes. The phrase "containing carbon as a main component" means that a content of carbon is 60% by mass or more, preferably 70% by mass or more, more preferably 80% by mass or more, still more preferably 85% by mass or more, particularly preferably 90% by mass or more, further preferably 95% by mass or more, still further preferably 99% by mass or more, with respect to a total amount of the carbon material.

Examples of the carbon material include carbon fibers, carbon blacks, carbon microcoils, and graphene.

When the electromagnetic wave absorbing thermally conductive material contains a carbon material, a content of the carbon material is preferably from 0.5% by mass to 30% by mass, more preferably from 3% by mass to 25% by mass, still more preferably from 5% by mass to 20% by mass, with respect to a total amount of the electromagnetic wave absorbing thermally conductive material.

(1.5) Additives and the like

The electromagnetic wave absorbing thermally conductive material may contain at least one of a soft magnetic material, a metal oxide, or an additive.

Examples of the soft magnetic material include metal-based soft magnetic materials, spinel ferrites, garnet ferrites, and hexagonal ferrites. Examples of the metal-based soft magnetic materials include amorphous alloys, electromagnetic steel sheets, and carbonyl iron. Examples of the spinel ferrites include Mn-Zn ferrites and Ni-Zn ferrites. Examples of the hexagonal ferrites include magnetoplumbite-type ferrites and ferroxplana-type ferrites.

Examples of the metal oxide include titanium oxide, barium titanate, iron oxide, and strontium titanate.

Examples of the additive include a dispersant, a surface modifier, a colorant, an antioxidant, a light stabilizer, a metal inactivator, a flame retardant, and an antistatic agent.

Examples of the dispersant include low-stereoregularity polyolefins and modified polyolefins.

Examples of the surface modifier include silane coupling agents, titanate coupling agents, zirconate coupling agents, and aluminate coupling agents.

The low-stereoregularity polyolefins may be commercially available products. Examples thereof include "L-MODU S400", "L-MODU S410", "L-MODU S600", and "L-MODU S901", which are manufactured by Idemitsu Kosan Co., Ltd.

The shapes of these soft magnetic materials and the like are not particularly limited and may be, for example, a spherical shape, a flat shape, or a fiber shape. The ratio of each of the additives and the like to be incorporated may be adjusted as appropriate within a range that does not impair the effects of the disclosure.

(1.6) Configuration of Electromagnetic Wave Absorbing Thermally Conductive Material

The electromagnetic wave absorbing thermally conductive material may have a single-layer configuration or a multi-layer configuration.

The single-layer configuration represents a molded body of the electromagnetic wave absorbing thermally conductive material itself.

The multi-layer configuration includes a magnetic loss layer and a dielectric loss layer. The magnetic loss layer and the dielectric loss layer are each formed of the components of the electromagnetic wave absorbing thermally conductive material. The multi-layer configuration is a sheet-like product.

The multi-layer configuration of the electromagnetic wave absorbing thermally conductive material is hereinafter referred to as "electromagnetic wave absorbing thermally conductive laminated sheet". The single-layer configuration of the electromagnetic wave absorbing thermally conductive material is hereinafter referred to as "electromagnetic wave absorbing thermally conductive molded body".

The electromagnetic wave absorbing thermally conductive laminated sheet and the electromagnetic wave absorbing thermally conductive molded body will now be described in this order.

(1.7) Electromagnetic Wave Absorbing Thermally Conductive Laminated Sheet

The electromagnetic wave absorbing thermally conductive laminated sheet includes a magnetic loss layer and a dielectric loss layer. The dielectric loss layer is laminated on at least one main surface of the magnetic loss layer. The magnetic loss layer contains a high-magnetic-permeability metal. The dielectric loss layer contains a thermoplastic resin and CNTs.

The electromagnetic wave absorbing thermally conductive laminated sheet has the above-described configuration and is, therefore, capable of not only removing electromagnetic waves in a low-frequency band but also efficiently conducting heat. The electromagnetic wave absorbing thermally conductive laminated sheet is also capable of shielding electromagnetic waves in a low-frequency band while absorbing electromagnetic waves in a high-frequency band.

The configuration of the electromagnetic wave absorbing thermally conductive laminated sheet is not particularly limited, and may be a two-layer configuration, a three-layer configuration, or a five-layer configuration.

The dielectric loss layer may be adhesive. In other words, the dielectric loss layer is a gel-like soft solid and may have a fluidity and a cohesive force. The "fluidity" refers to a property of a liquid that wets an adherend upon coming into contact. The "cohesive force" refers to a property of a solid that resists being peeled from an adherend.

In the two-layer configuration, the dielectric loss layer is directly laminated on one of the main surfaces of the magnetic loss layer.

The three-layer configuration includes a first three-layer configuration and a second three-layer configuration. In the first three-layer configuration, one of the dielectric loss layers is directly laminated on one of the main surfaces of the magnetic loss layer, and the other dielectric loss layer is directly laminated on the other main surface of the magnetic loss layer. In the second three-layer configuration, the dielectric loss layer is laminated on one of the main surfaces of the magnetic loss layer via an adhesive layer. The adhesive layer is a coating of a known adhesive layer. By this, the effects of the invention of the disclosure can be exerted even when electromagnetic waves are irradiated to either of the main surfaces of the electromagnetic wave absorbing thermally conductive laminated sheet.

In the five-layer configuration, one of the dielectric loss layers is laminated on one of the main surface of the magnetic loss layer via an adhesive layer, and the other dielectric loss layer is laminated on the other main surface of the magnetic loss layer via another adhesive layer.

The size of the electromagnetic wave absorbing thermally conductive laminated sheet is not particularly limited, and is selected as appropriate in accordance with the intended use and the like of the electromagnetic wave absorbing thermally conductive laminated sheet.

(1.7.1) Dielectric Loss Layer

The electromagnetic wave absorbing thermally conductive laminated sheet includes a dielectric loss layer.

The dielectric loss layer contains a thermoplastic resin and CNTs.

The imaginary part of the relative permittivity of the CNTs is high in a low-frequency band. The imaginary part of the relative permittivity of the CNTs represents a dielectric loss ($\varepsilon$"). Therefore, the CNTs convert the electrical energy of the electric field component of electromagnetic waves in a low-frequency band into heat. As a result, the dielectric loss layer can attenuate the electric field component of electromagnetic waves in a low-frequency band.

Further, the CNTs have an excellent thermal conductivity. Therefore, the dielectric loss layer efficiently conducts heat.

The thickness of the dielectric loss layer is selected as appropriate in accordance with the intended use and the like of the electromagnetic wave absorbing thermally conductive laminated sheet.

With regard to the thickness of the dielectric loss layer, the dielectric loss of the dielectric loss layer and the thermal conductivity of the dielectric loss layer have a trade-off relationship. Particularly, the larger the thickness of the dielectric loss layer, the more improved is the dielectric loss of the dielectric loss layer, and the more reduced is the thermal conductivity of the dielectric loss layer. On the other hand, the smaller the thickness of the dielectric loss layer, the more reduced is the dielectric loss of the dielectric loss layer, and the more improved is the thermal conductivity of the dielectric loss layer.

When the electromagnetic wave absorbing thermally conductive laminated sheet is used as a TIM (Thermal Interface Material), the thickness of the dielectric loss layer is preferably from 0.01 mm to 30 mm, more preferably from 0.05 mm to 20 mm, still more preferably from 0.1 mm to 10 mm. As long as the thickness of the dielectric loss layer is in this range, the electromagnetic wave absorbing thermally conductive laminated sheet can provide both a radiation noise measure and a heat dissipation measure.

When the electromagnetic wave absorbing thermally conductive laminated sheet is mainly used as a radiation noise measure, the thickness of the dielectric loss layer is preferably from 0.01 mm to 30 mm, more preferably from 0.05 mm to 20 mm, still more preferably from 0.1 mm to 10 mm. As long as the thickness of the dielectric loss layer is in this range, the electromagnetic wave absorbing thermally conductive laminated sheet can further remove radiation noise in a low-frequency band.

(1.7.1.1) Carbon Nanotubes

The dielectric loss layer contains CNTs.

The CNTs are preferably dispersed in the dielectric loss layer. In other words, the CNTs are preferably not aggregated in the dielectric loss layer.

By this, the dielectric loss layer can conduct heat more efficiently. In addition, when the CNTs are dispersed, the electromotive force of an eddy current against radio waves is less likely to be reduced as compared when the CNTs are aggregated. As a result, dispersed CNTs can convert radio waves into heat more efficiently. In other words, the dielectric loss layer can convert radio waves into heat more efficiently.

A method of dispersing the CNTs in the thermoplastic resin is not particularly limited, and examples thereof include a physical dispersion method and a chemical dispersion method. The physical dispersion method is a method that uses the above-described dispersant. The chemical dispersion method is a method of introducing functional groups to the surfaces of the CNTs. Particularly, the chemical dispersion method is a method that uses the above-described surface modifier.

The content of the CNTs is preferably from 0.5% by mass to 30% by mass, more preferably from 3% by mass to 25% by mass, still more preferably from 5% by mass to 20% by mass, with respect to a total amount of the dielectric loss layer.

As long as the content of the CNTs is in this range, the dielectric loss layer has a sufficient mechanical strength.

When the content of the CNTs is low, the dielectric loss layer tends to behave as a dielectric, and the viscosity of the raw materials of the dielectric loss layer as a composite material is unlikely to be increased, so that the raw materials of the dielectric loss layer can be easily molded. On the other hand, when the content of the CNTs is high, because of a percolation network of the CNTs, the dielectric loss layer not only tends to behave as a metal but also can efficiently convert radio waves into heat. As long as the content of the CNTs is in the above-described range, the dielectric loss layer is less likely to reflect radiation noise and can thus further remove radiation noise as compared to a case where the dielectric loss layer behaves as a metal.

(1.7.1.2) Thermoplastic Resin

The dielectric loss layer contains a thermoplastic resin.

The thermoplastic resin functions as a binder of the CNTs in the electromagnetic wave absorbing thermally conductive laminated sheet.

In addition, the thermoplastic resin has an electrical insulation property.

Particularly, when the CNTs are dispersed in the dielectric loss layer, the CNTs are readily polarized against radiation noise in a low-frequency band. As a result, the dielectric loss layer is more likely to remove radiation noise in a low-frequency band.

The dielectric loss layer contains such a thermoplastic resin and is thus adhesive and flexible. Therefore, the electromagnetic wave absorbing thermally conductive laminated sheet can be pasted to an arrangement position without having to interpose an adhesive layer therebetween. Further, the electromagnetic wave absorbing thermally conductive laminated sheet can be easily modified in shape and thus easily arranged even when the arrangement position has a complex shape.

From the standpoint of mechanical strength, heat resistance, and injection moldability, the thermoplastic resin preferably contains at least one of a polypropylene or a polyamide and, from the standpoint of stretchability into a sheet-like product at the time of molding the dielectric loss layer, the thermoplastic resin more preferably contains a polypropylene.

From the standpoint of mechanical strength, heat resistance, and moldability, the content of the thermoplastic resin is preferably 65.0% by mass to 99.5% by mass, more preferably 70.0% by mass to 99.5% by mass, still more preferably 80.0% by mass to 99.5% by mass, with respect to a total amount of the dielectric loss layer.

(1.7.1.3) Additives and the like

The dielectric loss layer may contain at least one of a carbon material, a soft magnetic material, a metal oxide, or an additive.

By incorporating a carbon material into the dielectric loss layer, the mechanical strength of the dielectric loss layer can be improved.

By incorporating a soft magnetic material into the dielectric loss layer, for example, the dielectric loss layer can further remove the magnetic component of radiation noise at higher frequencies than a low-frequency band.

The content of each of the carbon material, the soft magnetic material, the metal oxide, and the additive is preferably 10% by mass or less, more preferably 5% by mass or less, still more preferably 1% by mass or less, with respect to a total amount of the dielectric loss layer.

(1.7.2) Magnetic Loss Layer

The electromagnetic wave absorbing thermally conductive laminated sheet includes a magnetic loss layer.

The magnetic loss layer contains a high-magnetic-permeability metal, and preferably contains an Ni-based soft magnetic alloy or a nanocrystalline soft magnetic alloy.

The imaginary part of the relative magnetic permeability of the high-magnetic-permeability metal (e.g., the Ni-based soft magnetic alloy or the nanocrystalline soft magnetic alloy) is high in a low-frequency band. The imaginary part of the relative magnetic permeability of the high-magnetic-permeability metal (e.g., the Ni-based soft magnetic alloy or the nanocrystalline soft magnetic alloy) represents a magnetic loss ($\mu$"). Therefore, the high-magnetic-permeability metal (e.g., the Ni-based soft magnetic alloy or the nanocrystalline soft magnetic alloy) converts the magnetic energy of the magnetic field component of electromagnetic waves in a low-frequency band into heat. As a result, the magnetic loss layer can attenuate the electric field component of electromagnetic waves in a low-frequency band.

The high-magnetic-permeability metal (e.g., the Ni-based soft magnetic alloy or the nanocrystalline soft magnetic alloy) has an excellent thermal conductivity. Accordingly, the magnetic loss layer readily conducts heat. In addition, the soft magnetic metal is a highly magnetic-permeable metal, and thus has a high electrical conductivity and a favorable reflectance in the first place. Therefore, the magnetic loss layer can shield even the electromagnetic waves in a low-frequency band that could not be absorbed.

The magnetic loss layer may be a ribbon layer or a resin layer.

The ribbon layer includes a ribbon of the high-magnetic-permeability metal, and preferably includes a ribbon of an Fe-Ni-based soft magnetic alloy, or a ribbon of the nanocrystalline soft magnetic alloy.

The resin layer is formed of a resin and plural particles of the high-magnetic-permeability metal, and is preferably formed of a resin and plural particles of the Fe-Ni-based soft magnetic alloy or plural particles of the nanocrystalline soft magnetic alloy. The plural particles of the high-magnetic-permeability metal (e.g., the plural particles of the Fe-Ni-based soft magnetic alloy or the plural particles of the nanocrystalline soft magnetic alloy) may be dispersed in the resin.

The ribbon layer may have a single-layer configuration or a multi-layer configuration. In the single-layer configuration, the ribbon layer is formed of a single ribbon of the high-magnetic-permeability metal, and is preferably formed of a single ribbon of the Fe-Ni-based soft magnetic alloy or a single ribbon of the nanocrystalline soft magnetic alloy. In the multi-layer configuration, the ribbon layer is formed of plural ribbons of the high-magnetic-permeability metal and an adhesive layer, and is preferably formed of plural ribbons of the Fe-Ni-based soft magnetic alloy or plural ribbons of a nanocrystalline alloy, and an adhesive layer. The adhesive layer is interposed between adjacent ribbons of the high-magnetic-permeability metal, or between adjacent ribbons of the nanocrystalline alloy (e.g., between adjacent ribbons of the Fe-Ni-based soft magnetic alloy, or between adjacent ribbons of the nanocrystalline soft magnetic alloy).

The resin constituting the resin layer is, for example, a thermoplastic resin or a thermosetting resin. Examples of the thermoplastic resin constituting the resin layer include the same materials as those exemplified above as the thermoplastic resin constituting the dielectric loss layer. Examples of the thermosetting resin constituting the resin layer include phenolic resins, melamine resins, urea resins, polyurethane resins, epoxy resins, unsaturated polyester resins, and rubbers.

The thickness of the magnetic loss layer is selected as appropriate in accordance with the material and the like of the magnetic loss layer.

The thickness of the ribbon layer is preferably from 0.01 mm to 1 mm, more preferably from 0.02 mm to 0.5 mm.

The thickness of the resin layer is preferably from 0.01 mm to 30 mm, more preferably from 0.05 mm to 20 mm.

(1.7.3) Use of Electromagnetic Wave Absorbing Thermally Conductive Laminated Sheet

Examples of the use of the electromagnetic wave absorbing thermally conductive laminated sheet include a first use, a second use, and a third use.

The first use refers to the use as a TIM which also serves as a radiation noise measure.

The second use refers to the use for absorption of electromagnetic waves leaking from a contactless power supply apparatus that performs contactless power supply.

The third use refers to the use for absorption of electromagnetic waves inside a housing of an electronic device, an electronic control unit, an unmanned aerial vehicle, or a lithium secondary battery.

The term "unmanned aerial vehicle" used herein refers to any airplane, rotorcraft, glider, airship, and the like that can be used for air navigation without a person on board structurally and flown by remote operation or autonomous control.

Hereinafter, "housing of an electronic device, an electronic control unit, an unmanned aerial vehicle, or a lithium secondary battery" is referred to as "housing of an electronic device or the like".

The first use, the second use, and the third use of the electromagnetic wave absorbing thermally conductive laminated sheet will now be described in this order.

(1.7.3.1) First Use

In the first use, the electromagnetic wave absorbing thermally conductive laminated sheet is used as a TIM which also serves as a radiation noise measure.

In the first use, for example, the electromagnetic wave absorbing thermally conductive laminated sheet is arranged between a CPU and a heat sink. Examples of the heat sink include water-cooled heat sinks and air-cooled heat sinks. The CPU generates heat during operation. The temperature of the CPU during operation is, for example, from 40°C to 80°C. In addition, the CPU may emit radiation noise during operation.

The electromagnetic wave absorbing thermally conductive laminated sheet efficiently dissipates the heat of the CPU to the heat sink. Further, the electromagnetic wave absorbing thermally conductive laminated sheet is different from a conventional thermally conductive laminated sheet in that it can remove radiation noise in a low-frequency band that is cause by the operation of the CPU.

(1.7.3.2) Second Use

In the second use, the electromagnetic wave absorbing thermally conductive laminated sheet is used for absorption of electromagnetic waves leaking from a contactless power supply apparatus that performs contactless power supply.

The contactless power supply apparatus has a known configuration. The contactless power supply apparatus includes a power transmission device and a power receiving device. Electric power is transmitted from the power transmission device to the power receiving device in a contactless manner. The power transmission device includes a power transmission coil and a first housing. The first housing houses the power transmission coil. The power receiving device includes a power receiving coil and a second housing. The power receiving coil receives the electric power transmitted from the power transmission device. The second housing houses the power receiving coil. A power supply method of the contactless power supply apparatus is not particularly limited, and examples thereof include an electromagnetic induction method and a magnetic field resonance method.

In the disclosure, "electromagnetic waves leaking from a contactless power supply apparatus" refers to electromagnetic waves leaking from at least one of the first housing or the second housing.

The contactless power supply apparatus is used for, for example, an electric-powered vehicle. In this case, the power transmission device is stationary, and the power receiving device is mounted on the electric-powered vehicle.

Even when the first housing and the second housing that are included in the contactless power supply apparatus are each made of a metal, electromagnetic waves may leak from the contactless power supply apparatus depending on the frequency and the like of the electromagnetic waves.

In the second use, for example, the electromagnetic wave absorbing thermally conductive laminated sheet is attached to at least a portion of the outer peripheral surface of each of the first housing and the second housing. For example, when the first housing and the second housing each have an opening, the electromagnetic wave absorbing thermally conductive laminated sheet is attached to the first housing and the second housing in such a manner to cover the opening.

The electromagnetic wave absorbing thermally conductive laminated sheet can remove radiation noise in a low-frequency band that is caused by contactless power supply.

Examples of the electric-powered vehicles include electric-powered four-wheel vehicles and electric-powered two-wheel vehicles. The electric-powered four-wheel vehicles include electric vehicles (EVs), plug-in hybrid electric vehicles (PHEVs), and hybrid vehicles (HVs). The electric-powered two-wheel vehicles include electric motorcycles and electric assist bicycles.

(1.7.3.3) Third Use

In the third use, the electromagnetic wave absorbing thermally conductive laminated sheet is used for absorption of electromagnetic waves inside a housing of an electronic device or the like.

When the housing of an electronic device or the like is made of a metal, radiation noise inside the housing of an electronic device or the like is, upon coming into contact with the housing of an electronic device or the like, likely to be reflected by an eddy current generated on the surface of the housing.

Hereinafter, a housing of an electronic device or the like that is made of a metal may be referred to as "metal housing".

By this, a metal housing can inhibit the emission of radiation noise inside the metal housing. In addition, the metal housing has a resistance (immunity) to radiation noise coming from the outside of the metal housing.

The metal housing, however, cannot remove radiation noise due to the generation of an eddy current against the radiation noise.

In the third use, for example, the electromagnetic wave absorbing thermally conductive laminated sheet is attached to at least a portion of the inner peripheral wall of the metal housing. The electromagnetic wave absorbing thermally conductive laminated sheet can not only remove radiation noise in a low-frequency band inside the metal housing but also absorb radiation noise in a high-frequency band.

The electronic device is not particularly limited, and examples thereof include motor drive power converters of electric-powered vehicles, desk-top personal computers, laptop personal computers, tablet personal computers, mobile phones, smartphones, digital cameras, portable music players, electronic gaming devices, medical devices, and televisions.

The motor drive power converters of electric-powered vehicles drive electric motors. The motor drive power converters of electric-powered vehicles each include a forward converter (converter) and a reverse converter (inverter). The forward converter converts alternating current into direct current. The reverse converter convers the direct current into variable voltage and variable frequency. An on-off operation (switching) of an IGBT (Insulated Gate Bipolar Transistor) device included in the reverse converter is likely to be a noise source.

The electronic control unit is an electronic control circuit having a microcomputer as a main component. The microcomputer includes, for example, a CPU, a RAM (Random Access Memory), a ROM (Read Only Memory), a nonvolatile memory, and an interface (I/F). The CPU realizes various functions by executing the programs stored in the ROM. For example, in an electronic control unit for an electric-powered vehicle, the CPU controls the drive or general operation of the electric-powered vehicle.

Examples of the unmanned aerial vehicle include helicopters, multicopters having plural rotor blades (i.e. drones), and high-altitude drone unmanned aircrafts for HAPS stratospheric platform; High Altitude Platform Station).

Examples of the secondary battery include lithium ion batteries, lead batteries, nickel-cadmium batteries, and nickel-hydrogen batteries.

Particularly, the electromagnetic wave absorbing thermally conductive laminated sheet not only reduces the reflection of high-frequency electromagnetic waves and absorbs high-frequency electromagnetic waves but also shields low-frequency electromagnetic waves; therefore, among the above-described first to third uses, the electromagnetic wave absorbing thermally conductive laminated sheet is envisioned to be used by being pasted to each of the internal and external parts of an electric-powered four-wheel vehicle for the purpose of inhibiting interference with ADAS (Advanced Driver-Assistance Systems).

(1.8) Electromagnetic Wave Absorbing Thermally Conductive Molded Body

The electromagnetic wave absorbing thermally conductive molded body is a molded body formed of the electromagnetic wave absorbing thermally conductive material.

The electromagnetic wave absorbing thermally conductive molded body has the above-described configuration and is, therefore, capable of not only removing electromagnetic waves in a low-frequency band but also efficiently conducting heat. In addition, the electromagnetic wave absorbing thermally conductive molded body is capable of shielding electromagnetic waves in a low-frequency band while absorbing electromagnetic waves in a high-frequency band.

A form of the electromagnetic wave absorbing thermally conductive molded body is selected as appropriate in accordance with the intended use and the like of the electromagnetic wave absorbing thermally conductive molded body. The form of the electromagnetic wave absorbing thermally conductive molded body is, for example, a sheet-like product or a three-dimensional product. Examples of the three-dimensional product include a housing of an electronic device or the like, a pyramid shape, and a wedge shape.

A configuration in which the electromagnetic wave absorbing thermally conductive molded body is a housing of an electronic device or the like will be described below as an electromagnetic wave absorbing thermally conductive housing according to a second embodiment.

The thickness of the electromagnetic wave absorbing thermally conductive molded body is selected as appropriate in accordance with the intended use and the like of the electromagnetic wave absorbing thermally conductive molded body. The dielectric loss and the thermal conductivity of the electromagnetic wave absorbing thermally conductive molded body have a trade-off relationship in the same manner as the dielectric loss layer of the electromagnetic wave absorbing thermally conductive laminated sheet.

When the electromagnetic wave absorbing thermally conductive molded body is used as a TIM, the thickness of the electromagnetic wave absorbing thermally conductive molded body is preferably from 0.01 mm to 1 mm, more preferably from 0.02 mm to 0.5 mm, still more preferably from 0.05 mm to 0.5 mm. As long as the thickness of the electromagnetic wave absorbing thermally conductive molded body is in this range, the electromagnetic wave absorbing thermally conductive molded body can provide both a radiation noise measure and a heat dissipation measure.

When the electromagnetic wave absorbing thermally conductive molded body is mainly used as a radiation noise measure, the thickness of the electromagnetic wave absorbing thermally conductive molded body is preferably from 0.01 mm to 30 mm, more preferably from 0.05 mm to 20 mm, still more preferably from 0.1 mm to 10 mm. As long as the thickness of the electromagnetic wave absorbing thermally conductive molded body is in this range, the electromagnetic wave absorbing thermally conductive molded body can not only further remove radiation noise in a low-frequency band but also absorb radiation noise in a high-frequency band.

(1.8.1) Carbon Nanotubes

The electromagnetic wave absorbing thermally conductive molded body contains CNTs.

By this, the electromagnetic wave absorbing thermally conductive molded body can attenuate the electric field component of electromagnetic waves in a low-frequency band.

The CNTs are preferably dispersed in the electromagnetic wave absorbing thermally conductive molded body. In other words, the CNTs are preferably not aggregated in the electromagnetic wave absorbing thermally conductive molded body.

By this, the electromagnetic wave absorbing thermally conductive molded body can conduct heat more efficiently. In addition, when the CNTs are dispersed, the electromotive force of an eddy current against radio waves is less likely to be reduced as compared when the CNTs are aggregated. As a result, dispersed CNTs can convert radio waves into heat more efficiently. In other words, the electromagnetic wave absorbing thermally conductive molded body can convert radio waves into heat more efficiently.

A method of dispersing the CNTs in the electromagnetic wave absorbing thermally conductive molded body is not particularly limited, and examples thereof include a physical dispersion method and a chemical dispersion method.

The content of the CNTs is preferably from 0.5% by mass to 30% by mass, more preferably from 3% by mass to 25% by mass, still more preferably from 5% by mass to 20% by mass, with respect to a total amount of the electromagnetic wave absorbing thermally conductive molded body.

As long as the content of the CNTs is in this range, the electromagnetic wave absorbing thermally conductive molded body has a sufficient mechanical strength.

When the content of the CNTs is low, the electromagnetic wave absorbing thermally conductive molded body tends to behave as a dielectric, and the viscosity of the raw materials of the electromagnetic wave absorbing thermally conductive molded body as a composite material is unlikely to be increased, so that the raw materials of the electromagnetic wave absorbing thermally conductive molded body can be easily molded. On the other hand, when the content of the CNTs is high, because of a percolation network of the CNTs, the electromagnetic wave absorbing thermally conductive molded body not only relatively tends to behave as a metal but also can efficiently convert radio waves into heat. As long as the content of the CNTs is in the above-described range, the electromagnetic wave absorbing thermally conductive molded body is less likely to reflect radiation noise and can thus further remove radiation noise as compared to a case where the electromagnetic wave absorbing thermally conductive molded body behaves as a metal. The electromagnetic wave absorbing thermally conductive molded body, however, does not have a surface resistivity as low as that of a metal despite being said to behave as a metal; therefore, the electromagnetic wave absorbing thermally conductive molded body is characterized by being capable of efficiently absorbing electromagnetic waves without strong reflection.

(1.8.2) Thermoplastic Resin

The electromagnetic wave absorbing thermally conductive molded body contains a thermoplastic resin.

The thermoplastic resin functions as a binder of the CNTs and the high-magnetic-permeability metal in the electromagnetic wave absorbing thermally conductive molded body.

In addition, the thermoplastic resin has an electrical insulation property. Particularly, when the CNTs are dispersed in the electromagnetic wave absorbing thermally conductive molded body, the CNTs are readily polarized against radiation noise in a low-frequency band. As a result, the electromagnetic wave absorbing thermally conductive molded body is more likely to remove radiation noise in a low-frequency band.

The electromagnetic wave absorbing thermally conductive molded body contains such a thermoplastic resin and thus has a superior moldability as compared to a case where the electromagnetic wave absorbing thermally conductive molded body contains a thermosetting resin.

Particularly, from the standpoint of mechanical strength, heat resistance, and injection moldability, the thermoplastic resin preferably contains at least one of a polypropylene, a polyethylene, a polyester, or a polyamide and, from the standpoint of stretchability into a sheet-like product at the time of molding the electromagnetic wave absorbing thermally conductive molded body, the thermoplastic resin more preferably contains a polypropylene or a polyethylene.

From the standpoint of mechanical strength, heat resistance, and moldability, the content of the thermoplastic resin is preferably 65.0% by mass to 99.5% by mass, more preferably 70% by mass to 99.5% by mass, still more preferably 80% by mass to 99.5% by mass, with respect to a total amount of the electromagnetic wave absorbing thermally conductive molded body.

(1.8.3) High-Magnetic-Permeability Metal

The electromagnetic wave absorbing thermally conductive molded body contains a high-magnetic-permeability metal.

By this, the electromagnetic wave absorbing thermally conductive molded body can attenuate the magnetic field component of electromagnetic waves in a low-frequency band. In addition, the electromagnetic wave absorbing thermally conductive molded body can, through reflection, shield the electromagnetic waves that could not be attenuated. In other words, the electromagnetic wave absorbing thermally conductive molded body is capable of not only shielding electromagnetic waves in a low-frequency band but also absorbing electromagnetic waves in a high-frequency band.

The high-magnetic-permeability metal is preferably in the form of particles. A particulate nanocrystalline soft magnetic alloy contained in the high-magnetic-permeability metal is obtained by, for example, pulverizing the above-described ribbon by a known method.

The shape of the high-magnetic-permeability metal in the form of particles is not particularly limited and may be, for example, a spherical shape, a flat shape, or a fiber shape.

Examples of the material of this high-magnetic-permeability metal include the same materials as those exemplified above as the material of the high-magnetic-permeability metal of the electromagnetic wave absorbing thermally conductive laminated sheet.

From the standpoint of magnetic wave absorbing performance and mechanical strength, the content of the high-magnetic-permeability metal is preferably from 0.5% by mass to 30% by mass, more preferably from 1% by mass to 20% by mass, with respect to a total amount of the electromagnetic wave absorbing thermally conductive molded body.

(1.8.4) Additives and the like

The electromagnetic wave absorbing thermally conductive molded body may contain at least one of a carbon material, a soft magnetic material, a metal oxide, or an additive.

By incorporating a carbon material into the electromagnetic wave absorbing thermally conductive molded body, the mechanical strength of the electromagnetic wave absorbing thermally conductive molded body can be improved.

By incorporating a soft magnetic material into the electromagnetic wave absorbing thermally conductive molded body, for example, the electromagnetic wave absorbing thermally conductive molded body can further remove the magnetic component of radiation noise at higher frequencies than a low-frequency band.

The content of each of the carbon material, the soft magnetic material, the metal oxide, and the additive is preferably 20% by mass or less, more preferably 10% by mass or less, still more preferably 5% by mass or less, with respect to a total amount of the electromagnetic wave absorbing thermally conductive molded body.

(1.8.5) Use of Electromagnetic Wave Absorbing Thermally Conductive Molded Body

The use of the electromagnetic wave absorbing thermally conductive molded body is selected as appropriate in accordance with the form and the like of the electromagnetic wave absorbing thermally conductive molded body. When the electromagnetic wave absorbing thermally conductive molded body is in the form of a sheet, examples of the use of the electromagnetic wave absorbing thermally conductive molded body include the same ones as those exemplified above for the electromagnetic wave absorbing thermally conductive laminated sheet.

When the electromagnetic wave absorbing thermally conductive molded body is in the form of a housing of an electronic device or the like, the electromagnetic wave absorbing thermally conductive molded body is used as a housing of an electronic device or the like.

(2) Electromagnetic Wave Absorbing Thermally Conductive Housing According to First Embodiment

The electromagnetic wave absorbing thermally conductive housing according to a first embodiment of the disclosure includes: a housing of an electronic device or the like; and the electromagnetic wave absorbing thermally conductive laminated sheet of the disclosure. The electromagnetic wave absorbing thermally conductive laminated sheet is attached to an inside of the housing.

The electromagnetic wave absorbing thermally conductive housing of the disclosure has the above-described configuration is and, therefore, capable of removing radiation noise inside the housing of an electronic device or the like.

The housing of an electronic device or the like is a known housing.

The housing of an electronic device or the like is molded for housing therein an electronic device, an electronic control unit, an unmanned aerial vehicle, or a lithium secondary battery.

The housing of an electronic device or the like may be made of a metal or a resin.

When the housing of an electronic device or the like is made of a resin, the housing of an electronic device or the like is hereinafter referred to as "resin housing".

The electromagnetic wave absorbing thermally conductive housing of the disclosure includes the electromagnetic wave absorbing thermally conductive laminated sheet and, therefore, is capable of removing radiation noise inside a metal housing of an electronic device or the like. In addition, the electromagnetic wave absorbing thermally conductive housing of the disclosure can absorb electromagnetic waves in a high-frequency band.

The weight of a resin housing is lighter than that of a metal housing. Meanwhile, resins are generally transparent to electromagnetic waves. In other words, generally, a resin housing cannot shield radiation noise inside the resin housing. Since the electromagnetic wave absorbing thermally conductive housing of the disclosure includes the electromagnetic wave absorbing thermally conductive laminated sheet, it is capable of removing radiation noise inside a resin housing. As a result, the electromagnetic wave absorbing thermally conductive housing can inhibit the emission of radiation noise inside the resin housing. In addition, the electromagnetic wave absorbing thermally conductive housing has a resistance (immunity) to radiation noise coming from the outside of the resin housing. Further, the electromagnetic wave absorbing thermally conductive housing can absorb electromagnetic waves in a high-frequency band.

The material of the metal housing is not particularly limited, and examples thereof include iron, copper, nickel, gold, silver, platinum, cobalt, zinc, lead, tin, titanium, chromium, aluminum, magnesium, manganese, and alloys thereof (e.g., stainless steel, brass, and phosphor bronze). Examples of a metal material constituting the housing of an electronic device or the like include magnetic steel sheets.

Particularly, from the standpoint of thermal conductivity, the material of the metal housing is preferably aluminum, an aluminum alloy, copper, or a copper alloy, more preferably copper or a copper alloy. From the standpoint of reducing the weight and ensuring the strength, the material of the metal housing is preferably aluminum or an aluminum alloy.

The metal housing may be a die-cast product or a metal-cut product.

Examples of the material of the resin housing include thermoplastic resins (including elastomers) and thermosetting resins. Examples of the thermoplastic resins (including elastomers) include polyolefin resins, polyvinyl chlorides, polyvinylidene chlorides, polystyrene resins, acrylonitrile-styrene copolymer (AS) resins, acrylonitrile-butadiene-styrene copolymer (ABS) resins, polyester resins, poly(meth)acrylic resins, polyvinyl alcohols, polycarbonate resins, polyamide resins, polyimide resins, polyether resins, polyacetal resins, fluorine resins, polysulfone resins, polyphenylene sulfide resins, and polyketone resins. Examples of the thermosetting resins include phenolic resins, melamine resins, urea resins, polyurethane resins, epoxy resins, and unsaturated polyester resins. These resins may be used singly, or in combination of two or more kinds thereof.

The resin housing may be an injection-molded product.

(3) Electromagnetic Wave Absorbing Thermally Conductive Housing According to Second Embodiment

The electromagnetic wave absorbing thermally conductive housing according to a second embodiment is an electromagnetic wave absorbing thermally conductive housing obtained by molding the electromagnetic wave absorbing thermally conductive material of the disclosure. The electromagnetic wave absorbing thermally conductive housing according to the second embodiment is used for housing an electronic device, an electronic control unit, an unmanned aerial vehicle, or a lithium secondary battery.

The electromagnetic wave absorbing thermally conductive housing according to the second embodiment has the above-described configuration and is, therefore, capable of removing radiation noise inside a housing of an electronic device or the like. As a result, the electromagnetic wave absorbing thermally conductive housing according to the second embodiment can inhibit the emission of radiation noise inside the housing. In addition, the electromagnetic wave absorbing thermally conductive housing according to the second embodiment not only has a resistance (immunity) to radiation noise coming from the outside of the housing, but also can absorb electromagnetic waves in a high-frequency band.

Further, the electromagnetic wave absorbing thermally conductive housing according to the second embodiment is lighter than a metal housing.

The shape of the electromagnetic wave absorbing thermally conductive housing may be any known shape for housing an electronic device, an electronic control unit, an unmanned aerial vehicle, or a lithium secondary battery.

EXAMPLES

Embodiments of the disclosure will now be described in detail referring to Examples. It is noted here, however, that the disclosure is not limited to the below-described Examples by any means.

[1] Production of Radio Wave Absorbing Thermally Conductive Material

[1.1] Preparation

Components used in Examples and Comparative Examples are as follows.

<Carbon Nanotubes>

- Multi-walled carbon nanotubes: "NC7000" manufactured by Nanocyl SA (average diameter: 9.5 nm, average length: 1.5 $\mu$m, form: powder, Layer configuration: multi-layer)

<Thermoplastic Resins>

- Polypropylene: "PRIME POLYPRO (registered trademark) J707G" manufactured by Prime Polymer Co., Ltd.
- Polyethylene: "EVOLUE (registered trademark) SP2540" manufactured by Prime Polymer Co., Ltd.
- Polyamide: "AMILAN CM1007" manufactured by Toray Industries, Inc.
- SEBS: "TUFTEC (registered trademark) H1521" manufactured by Asahi Kasei Corporation

<Carbon Materials>

- Carbon black: Mitsubishi CARBON BLACK "#3400B" (average particle size: 21 nm) manufactured by Mitsubishi Chemical Corporation
- Graphene: graphene powder "06-0318" (specific surface area: 700 m$^2$/g) manufactured by FUJIFII,M Wako Pure Chemical Corporation

<Additive>

- Dispersant: "L-MODU S400" (low-stereoregularity polyolefin, Mw = 45,000, (Mw/Mn) = 2, softening point = 93°C) manufactured by Idemitsu Kosan Co., Ltd. <Antioxidants>
- Hindered phenol-based antioxidant ("IRGANOX 1010" manufactured by BASF Japan, Ltd., chemical formula: pentaerythritol tetrakis[3-(3,5-di-*tert*-butyl-4-hydroxyphenyl)propionate])

- Phosphorus-based processing stabilizer ("IRGAFOS 168" manufactured by BASF Japan, Ltd., chemical formula: tris(2,4-di-*tert*-butylbenzene)phosphite)

<Nanocrystalline Soft Magnetic Alloys>

- Amorphous metal band: FINEMET (registered trademark) "FT-3M" (component: Fe-Cu-Nb-Si-B-based alloy, thickness: 18 μm) manufactured by Hitachi Metals Ltd.
- Soft magnetic metal band: PERMALLOY (registered trademark) "MEMPC-2S" (component: Fe-Ni-based alloy, thickness: 20 μm) manufactured by Daido Steel Co., Ltd.

[1.2] Example 1

[1.2.1] Production of Dielectric Loss Film

The multi-walled carbon nanotubes and the dispersant were added to an FM mixer ("FM10C/I" manufactured by Nippon Coke & Engineering Co., Ltd., capacity: 9 L) at the content ratio shown in Table 1. These materials were mixed with stirring under the following conditions: stirring temperature = 140°C, stirring time = 60 minutes, and screw rotation speed = 1,000 rpm (revolutions per minute). By this, a mixed powder was obtained.
The thus obtained mixed powder and a thermoplastic resin were dry-blended at the content ratio shown in Table 1 to obtain a dry blend.
A twin-screw extruder ("TEM-35B" manufactured by Toshiba Machine Co., Ltd., screw diameter: 35 mm, L/D: 32, vent-type) was prepared. A die having a strand recovery hole of 3 mm in diameter was attached to the outlet of the twin-screw extruder.
The dry blend was added to this twin-screw extruder and melt-kneaded at a kneading temperature of 230°C and a screw rotation speed of 100 rpm. The resulting melt-kneaded product was extruded through the die to obtain a strand-form product. This strand-form product was cooled in a water bath and then cut using a strand cutter, whereby pellets were obtained.
The thus obtained pellets (99.6% by mass), the hindered phenol-based antioxidant (0.2% by mass), and the phosphorus-based processing stabilizer (0.2% by mass) were added to a kneading extruder ("KZW-15TW" manufactured by Technovel Corporation, screw diameter: 15 mmcp), and kneaded and granulated at a kneading temperature of 230°C and a screw rotation speed of 100 rpm, whereby a granulated product was obtained.
The thus obtained granulated product was added to the below-described injection molding machine (manufactured by Toshiba Machine Co., Ltd.), and injection-molded using a 12 cm × 13 cm × 1 mmt mold at a mold temperature of 40°C and a cylinder temperature of 230°C to obtain a dielectric loss film having a thickness of 1 mmt.

<Injection Molding Machine>

- Molding machine: "IS-55EPN" manufactured by Shibaura Machine Co., Ltd.
- Mold temperature controller: "MCX-200" manufactured by Matsui MFG. Co., Ltd.

[1.2.2] Production of Radio Wave Absorbing Thermally Conductive Material

Using a vacuum press machine (manufactured by Kansai Roll Co., Ltd.), the thus obtained dielectric loss film was press-bonded to both main surfaces of the amorphous metal band in a vacuum atmosphere under the following conditions: temperature = 210°C, pressure = 7 MPa, and press-bonding time = 10 minutes. At the time of this press-bonding, a urethane-based adhesive (TAKELAC A-1121/TAKENATE A-81, manufactured by Mitsui Chemicals, Inc.) was applied as a thin layer to both main surfaces of the amorphous metal band. By this, a radio wave absorbing thermally conductive material was obtained.
The thus obtained radio wave absorbing thermally conductive material of Example 1 was formed of the amorphous metal band and the dielectric loss films laminated on both main surfaces of the amorphous metal band. In other words, the radio wave absorbing thermally conductive material of Example 1 had a three-layer configuration.

[1.3] Examples 2 to 9 (excluding Examples 4 and 7)

Radio wave absorbing thermally conductive materials were obtained in the same manner as in Example 1, except that the content of the multi-walled carbon nanotubes, the type and the content of the thermoplastic resin, and the content of the dispersant were changed as shown in Table 1.

The thus obtained radio wave absorbing thermally conductive materials of Examples 2, 3, 5, 6, 8, and 9 all had a three-layer configuration in the same manner as in Example 1.

[1.4] Example 4

The granulated product obtained in Example 1 was added to a twin-screw extruder, and melt-kneaded at a melting temperature of 230°C and a screw rotation speed of 63 rpm. Using the below-described film production apparatus, the thus obtained melt-kneaded product was extruded through a T-die to obtain a film-form product. This film-form product was cooled in a heated water circulation bath and then rolled up using a haul-off unit. In this process, the roll surface temperature of the haul-off unit was 50°C. By this, a dielectric loss film having a thickness of 100 μm was obtained.

<Film Production Apparatus>

- Twin-screw extruder: "2D30W2" and "LABO-PLASTOMILL 4C150" manufactured by Toyo Seiki Seisaku-sho, Ltd.
- Feeder: cassette weighing feeder manufactured by Kubota Corporation
- T-die: "T150C" manufactured by Toyo Seiki Seisaku-sho, Ltd.
- Haul-off unit: "FT2W20" manufactured by Toyo Seiki Seisaku-sho, Ltd.
- Heated water circulation bath: "TBT220DA" manufactured by ADVANTEC Toyo Co., Ltd.

The thus obtained dielectric loss film was laminated on both main surfaces of the amorphous metal band by vacuum pressing in the same manner as in Example 1 to obtain a radio wave absorbing thermally conductive material.

[1.5] Comparative Examples 1 to 4 and 6

Radio wave absorbing thermally conductive materials were obtained in the same manner as in Example 1, except that the content of each of the multi-walled carbon nanotubes, the polypropylene, and the dispersant were changed as shown in Table 2, and that a dielectric loss film was not press-bonded to the amorphous metal band.

In other words, the radio wave absorbing thermally conductive materials of Comparative Examples 1 to 4 and 6 each consists of only a dielectric loss film.

[1.6] Comparative Example 5

The radio wave absorbing thermally conductive material of Comparative Example 5 consists of only the amorphous metal band.

[1.7] Comparative Example 7

The radio wave absorbing thermally conductive material of Comparative Example 7 consists of only the soft magnetic metal band.

[1.8] Comparative Example 8

The radio wave absorbing thermally conductive material of Comparative Example 8 is an electromagnetic wave shielding sheet "SF-PC 5000" manufactured by Tatsuta Electric Wire & Cable Co., Ltd. A polyimide is used as a base material, and the surface thereof is sputtered with silver ions using a sputtering device.

[1.9] Comparative Examples 9 and 10

Radio wave absorbing thermally conductive materials were obtained in the same manner as in Comparative Example 1, except that the content of the multi-walled carbon nanotubes, the content of the polypropylene, the content of the carbon nanotubes, the type and the content of the carbon material, and the content of the dispersant were changed as shown in Table 2.

[2] Measurement

[2.1] Measurement of Dielectric Loss Tangent $D\varepsilon$

The dielectric loss of each of the above-obtained radio wave absorbing thermally conductive materials was quantitatively evaluated based on the dielectric loss tangent $D\varepsilon$ in the following manner. The dielectric loss tangent $D\varepsilon$ is represented by $(\varepsilon''/\varepsilon')$ or a dielectric loss factor $\tan\delta$, wherein $\varepsilon''$ represents an imaginary part of relative permittivity, $\varepsilon'$ represents a real part of relative permittivity, and $\delta$ in the dielectric loss factor $\tan\delta$ represents a loss angle. The dielectric loss tangent $D\varepsilon$ is generally used as an index that represents a loss of a dielectric material.
A complex permittivity measurement test of each radio wave absorbing thermally conductive material was carried out under the below-described first test conditions. By this, the dielectric loss tangent $D\varepsilon$ at the measurement frequency of 100 kHz was determined.
The results of measuring the dielectric loss tangent $D\varepsilon$ at the measurement frequency of 100 kHz are shown in Tables 1 and 2.
An acceptable range of the dielectric loss tangent $D\varepsilon$ is 0.10 or more.

<First Test Conditions>

    Measurement apparatus: LCR meter ("4284A" manufactured by Agilent Technologies, Inc.)
    Measurement frequency: 100 kHz
    Test piece dimension: about 1 mm in thickness
    Number of samples: n = 1
    Electrode: tin foil diameter = main electrode $\varphi$37 mm
    Measurement temperature: room temperature = 23 $\pm$ 2°C

[2.2] Measurement of Magnetic Loss Tangent $D\mu$

The magnetic loss of each of the above-obtained radio wave absorbing thermally conductive materials was quantitatively evaluated based on the magnetic loss tangent $D\mu$ in the following manner. As in the case of an electric field, the magnetic loss tangent $D\mu$ is important for a magnetic field. In the same manner as the dielectric loss tangent, the magnetic loss tangent $D\mu$ is represented by $(\mu''/\mu')$ or a magnetic loss factor $\tan\delta$, wherein $\mu''$ represents an imaginary part of relative magnetic permeability, $\mu'$ represents a real part of relative magnetic permeability, and $\delta$ in the magnetic loss factor $\tan\delta$ represents a loss angle. The magnetic loss tangent $D\mu$ is generally used as an index that represents a loss of a magnetic material.
A magnetic wave absorption rate measurement test of each radio wave absorbing thermally conductive material was carried out under the below-described second test conditions. By this, the magnetic loss tangent $D\mu$ at the measurement frequency of 100 kHz was determined.
The results of measuring the magnetic loss tangent $D\mu$ at the measurement frequency of 100 kHz are shown in Tables 1 and 2.
An acceptable range of the magnetic loss tangent $D\mu$ is 0.15 or more.

<Second Test Conditions>

    Measurement apparatus: LCR meter (Keysight E4980AL 20 Hz - 1 MHz)
    Measurement frequency: 100 kHz
    Measurement temperature: room temperature = 26°C
    Measurement humidity: 60%

[2.3] Measurement of Shielding Performance (dB) against Electromagnetic Waves in Low-Frequency Band

The shielding performance (dB) of each of the above-obtained radio wave absorbing thermally conductive materials against electromagnetic waves in a low-frequency band (from 100 kHz to 1 GHz) was quantitatively evaluated by the KEC method.

The "KEC method" refers to a method of measuring the shielding performance in a near field, which method was developed by General Incorporated Association KEC Electronic Industry Development Center. The shielding performance quantified by the KEC method is represented by a difference between the receiving intensity measured when a sample is sandwiched and the receiving intensity measured when the sample is not sandwiched.

The measurement results obtained with the measurement frequency being set at 100 kHz, the measurement results obtained with the measurement frequency being set at 10 MHz, and the measurement results obtained with the measurement frequency being set at 1 GHz are shown in Tables 1 and 2.

An acceptable range of the shielding performance at a measurement frequency set at 100 kHz is 20 dB or more.

An acceptable range of the shielding performance at a measurement frequency set at 10 MHz is 70 dB or more.

An acceptable range of the shielding performance at a measurement frequency set at 1 GHz is 40 dB or more.

[2.4] Measurement of Shielding Performance, Reflection Performance, and Absorption Performance against Electromagnetic Waves in High-Frequency Band

The shielding performance, the reflection performance, and the absorption performance of each of the above-obtained radio wave absorbing thermally conductive materials against electromagnetic waves in a high-frequency band (76 GHz) was quantitatively evaluated by a free space method.

In the above-described KEC method, electromagnetic waves of up to several GHz can be measured; however, a free space method or a resonance method is employed for the measurement of electromagnetic waves in a higher frequency band. A resonance method has limitations in terms of the processing and the type of a sample (a metal cannot be measured); therefore, the measurement was carried out by a free space method.

[2.4.1] Shielding Performance

In an electromagnetic anechoic chamber, each radio wave absorbing thermally conductive material was sandwiched and immobilized between a transmitting antenna (S 1) and a receiving antenna (2) that were arranged to face each other. Under the below-described third test conditions, electromagnetic waves in a high-frequency band (76 GHz) were transmitted from the transmitting antenna (S1), and the transmission intensity ($E_{T1}$) received by the receiving antenna (2) was measured (hereinafter, referred to as "measurement of transmitted component").

On another front, the transmission intensity ($E_{T0}$) was measured in the same manner as the above-described measurement of transmitted component, except that the radio wave absorbing thermally conductive material was not arranged between the transmitting antenna (S1) and the receiving antenna (2).

The transmittance quantified by the free space method is represented by a ratio ($E_{T1}/E_{T0}$) (%) (hereinafter, referred to as "transmittance S21 ") of the transmission intensity ($E_{T1}$) measured when the radio wave absorbing thermally conductive material was sandwiched with respect to the transmission intensity ($E_{T0}$) measured when the radio wave absorbing thermally conductive material was not sandwiched.

The shielding performance quantified by the free space method is represented by a value (%) obtained by subtracting the transmittance S21 (%) from 100%.

The results of measuring the shielding performance are shown in Tables 1 and 2.

An acceptable shielding performance is 90% or more.

(Third Test Conditions)

Network analyzer: "5290A" manufactured by Keysight Technologies, Inc.
Millimeter-wave controller: "N5250CX10" manufactured by Keysight Technologies, Inc.
Transmitting/receiving antennas: horn antennas for millimeter-wave measurement, manufactured by KEYCOM Corporation
Coaxial cable: 2.4-mm connector-cable assembly manufactured by W.L. Gore & Associates G.K.
Distance between transmitting antenna and receiving antenna: 300 mm
Measurement frequency: 76 GHz

[2.4.2] Reflection Performance

Electromagnetic waves in a high-frequency band (76 GHz) were transmitted from the transmitting antenna (S1) and the reflection intensity ($E_{R1}$) received by a receiving antenna (1) was measured in the same manner as the above-described measurement of transmitted component, except that the receiving antenna (1) was further arranged on the same side as the transmitting antenna (S1) in relation to the radio wave absorbing thermally conductive material.

The reflection performance quantified by the free space method is represented by a ratio ($E_{R1}/(E_{T1} + E_{R1})$) (%) (hereinafter, referred to as "reflectance 11") of the reflection intensity ($E_{R1}$) with respect to a total amount of the transmission intensity ($E_{T1}$) and the reflection intensity ($E_{R1}$).

The results of measuring the reflection performance are shown in Tables 1 and 2.

An acceptable reflection performance is 50% or less.

[2.4.3] Absorption Performance

The absorption performance quantified by the free space method is represented by a value (%) obtained by subtracting the reflection intensity ($E_{R1}$) from the transmission intensity ($E_{T1}$).

The results of measuring the absorption performance are shown in Tables 1 and 2.

An acceptable absorption performance is 50% or more.

[2.5] Measurement of Thermal Conductivity (W/m$^2$)

The thermal conductivity (W/m$^2$) of each of the above-obtained radio wave absorbing thermally conductive materials was measured in the following manner. It is noted here that, in Examples 1 and 2, the thermal conductivity (W/m$^2$) was measured for each of the dielectric loss layer and the magnetic loss layer of the respective radio wave absorbing thermally conductive materials.

The thermal conductivity (W/m$^2$) of each of the above-obtained radio wave absorbing thermally conductive materials was analyzed by the method according to ASTM E1530 under the below-described fourth test conditions.

The measurement results are shown in Tables 1 and 2.

An acceptable range of the thermal conductivity (W/m$^2$) of each radio wave absorbing thermally conductive material is 0.3 W/m$^2$ or more.

<Fourth Test Conditions>

Test apparatus: "GH-1" manufactured by ULVAC-RIKO, Inc.
Preset temperature: 30°C
Preset air pressure for sample retention: 0.3 MPa
Test piece shape: about 50 mmφ
Number of measurements: n = 1

[Table 1]

| | Electromagnetic wave absorbing thermally conductive material | | | | | | | | Measurement results | | | | | | | | | Dielectric loss layer | Magnetic loss layer |
| | Dielectric loss layer | | | | | Magnetic loss layer | | | Electromagnetic wave absorbing thermally conductive material | | | | | | | | | | |
| | Thermoplastic resin | | CNT | Carbon material | | Additive | High-magnetic-permeability metal | | | Loss factor of material | | Shielding performance | | | | Reflection performance | Absorption performance | | |
| | | | | CB | Graphene | Dispersant | | Sheet thickness | 100 kHz | | KEC method | | | Free space method | Freespace method | Freespace method | Thermal conductivity | Thermal conductivity |
| | Type | Content | Content | Content | Content | Content | Type | | Dielectric loss tangent | Magnetic loss tangent | 100 kHz | 10 MHz | 1GHz | 76 GHz | 76 GHz | 76 GHz | | |
| | | (% by mass) | (% by mass) | (% by mass) | (% by mass) | (% by mass) | | (mm) | $D\varepsilon$ | $D\mu$ | (dB) | (dB) | (dB) | (%) | (%) | (%) | (W/m²) | (W/m²) |
| Example 1 | PP | 68.0 | 15.0 | - | - | 17.0 | amorphous metal band | 202 | 0.47 | 0.3 | 25< | 80< | 49 | 99.7 | 29 | 70.7 | 0.4 | 7.1 |
| Example 2 | PP | 83.5 | 15.0 | - | - | 1.5 | amorphous metal band | 202 | 0.47 | 0.3 | 25< | 80< | 49 | 99.7 | 29 | 70.7 | 0.4 | 7.1 |
| Example 3 | PP | 74.0 | 7.5 | - | - | 18.5 | amorphous metal band | 202 | 0.29 | 0.3 | 25< | 80< | 47 | 99.7 | 34 | 66 | 0.3 | 7.1 |
| Example 4 | PP | 83.5 | 15.0 | - | - | 1.5 | amorphous metal band | 0.30 | 0.47 | 0.3 | 25< | 80< | 49 | 99.7 | 29 | 70.7 | 0.4 | 7.1 |
| Example 5 | PP | 91.8 | 7.5 | - | - | 0.8 | soft magnetic metal band (PERMALLOY) | 2.02 | 0.29 | 0.1 | 25< | 80< | 47 | 99.7 | 40 | 60 | 0.3 | 7.1 |
| Example 6 | PE | 91.8 | 7.5 | - | - | 0.8 | amorphous metal band | 202 | - | - | 25< | 80< | 44 | 99.7 | 40 | 60 | 0.3 | 7.1 |
| Example 7 | PA | 91.8 | 7.5 | - | - | 0.8 | amorphous metal band | 202 | - | - | 25< | 80< | 44 | 99.7 | 40 | 60 | 0.3 | 7.1 |

| | Electromagnetic wave absorbing thermally conductive material | | | | | | | | Measurement results | | | | | | | | | |
| --- | --- | --- | --- | --- | --- | --- | --- | --- | --- | --- | --- | --- | --- | --- | --- | --- | --- | --- |
| | Dielectric loss layer | | | | | | Magnetic loss layer | Sheet thickness | Electromagnetic wave absorbing thermally conductive material | | | | | | Reflection performance | Absorption performance | Dielectric loss layer | Magnetic loss layer |
| | Thermoplastic resin | | CNT | Carbon material | | Additive | High-magnetic-permeability metal | | Loss factor of material | | Shielding performance | | | Free space method | Freespace method | Freespace method | Thermal conductivity | Thermal conductivity |
| | | | | CB | Graphene | Dispersant | | | 100 kHz | | KEC method | | | | | | | |
| | Type | Content | Content | Content | Content | Content | Type | | Dielectric loss tangent $D\varepsilon$ | Magnetic loss tangent $D\mu$ | 100 kHz | 10 MHz | 1GHz | 76 GHz | 76 GHz | 76 GHz | | |
| | | (% by mass) | (% by mass) | (% by mass) | (% by mass) | (% by mass) | | (mm) | | | (dB) | (dB) | (dB) | (%) | (%) | (%) | (W/m²) | (W/m²) |
| Example 8 | SEBS | 91.8 | 7.5 | - | - | 0.8 | amorphous metal band | 202 | - | - | 25< | 80< | 44 | 99.7 | 40 | 60 | 0.3 | 7.1 |

[Table 2]

| | Electromagnetic wave absorbing thermally conductive material | | | | | | | | Measurement results | | | | | | | | Dielectric loss layer | Magnetic loss layer |
|---|---|---|---|---|---|---|---|---|---|---|---|---|---|---|---|---|---|---|
| | Dielectric loss layer | | | | | | Magnetic loss layer | | Electromagnetic wave absorbing thermally conductive material | | | | | | | | | |
| | Thermoplastic resin | | CNT | Carbon material | | Additive | High-magnetic-permeability metal | Sheet thickness | Loss factor of material | | Shielding performance | | | Reflection performance | Absorption performance | | | |
| | | | | CB | Graphene | Dispersant | | | 100 kHz | | KEC method | | | Free space method | Free space method | Free space method | Thermal conductivity | Thermal conductivity |
| | Type | Content | Content | Content | Content | Content | Type | | Dielectric loss tangent | Magnetic loss tangent | 100 kHz | 10 MHz | 1 GHz | 76 GHz | 76 GHz | 76 GHz | | |
| | | (% by mass) | (% by mass) | (% by mass) | (% by mass) | (% by mass) | | (mm) | $D\varepsilon$ | $D\mu$ | (dB) | (dB) | (dB) | (%) | (%) | (%) | (W/m²) | (W/m²) |
| Comparative Example 1 | PP | 100.0 | 80< | - | - | - | - | 1.00 | 000 | 0.0 | 0 | 0 | 0 | 0 | 0 | 0 | 0.2 | - |
| Comparative Example 2 | PP | 64.0 | 200 | - | - | 16.0 | - | 1.00 | 0.62 | 0.0 | 25< | 65 | 37 | - | - | - | 0.5 | - |
| Comparative Example 3 | PP | 68.0 | 15.0 | - | - | 17.0 | - | 1.00 | 0.47 | 0.0 | 25< | 55 | 35 | - | - | - | 0.4 | - |
| Comparative Example 4 | PP | 74.0 | 7.5 | - | - | 18.5 | - | 1.00 | 0.23 | 0.0 | 25< | 20 | 10 | - | - | - | 0.3 | - |
| Comparative Example 5 | - | - | - | - | - | - | amorphous metal band | 0.02 | 000 | 0.3 | 25< | 55 | 45 | 99.7 | 99 | 0.7 | - | 7.1 |
| Comparative Example 6 | PP | 96.7 | 3.0 | - | - | 0.3 | - | 1.00 | 0.10 | 0.0 | 5 | 20 | 5 | - | - | - | 02 | - |

| | Electromagnetic wave absorbing thermally conductive material | | | | | | | | Measurement results | | | | | | | | Dielectric loss layer | Magnetic loss layer |
|---|---|---|---|---|---|---|---|---|---|---|---|---|---|---|---|---|---|---|---|
| | Dielectric loss layer | | | | | Magnetic loss layer | | | Electromagnetic wave absorbing thermally conductive material | | | | | | Reflection performance | Absorption performance | | | |
| | Thermoplastic resin | | CNT | Carbon material | | Additive | High-magnetic-permeability metal | | Loss factor of material | | Shielding performance | | | Free space method | Free space method | Free space method | Thermal conductivity | Thermal conductivity |
| | | | | CB | Graphene | Dispersant | | Sheet thickness | 100 kHz | | KEC method | | | 76 GHz | 76 GHz | 76 GHz | | |
| | Type | Content (% by mass) | Content (% by mass) | Content (% by mass) | Content (% by mass) | Content (% by mass) | Type | (mm) | Dielectric loss tangent $D\varepsilon$ | Magnetic loss tangent $D\mu$ | 100 kHz (dB) | 10 MHz (dB) | 1 GHz (dB) | 76 GHz (%) | 76 GHz (%) | 76 GHz (%) | (W/m²) | (W/m²) |
| Comparative Example 7 | - | - | - | - | - | - | soft magnetic metal band (PERMALLOY) | 0.02 | 000 | 0.1 | 25< | 80< | 45 | 99.7 | 99 | 0.7 | - | 8 |
| Comparative Example 8 | PI | 1000 | - | - | - | - | silver ion sputtering | 0.05 | - | - | 25< | 80< | 45 | 99 | 90 | 9 | - | - |
| Comparative Example 9 | PP | 90.0 | - | 100 | - | - | - | 1.00 | 0.01 | 0.3 | 0 | 0 | 0 | - | - | - | - | - |
| Comparative Example 10 | PP | 90.0 | - | - | 100 | - | - | 1.00 | 0.06 | 0.3 | 4 | 5 | 4 | - | - | - | - | - |

In Tables 1 and 2, under the item "Electromagnetic wave absorbing thermally conductive material": "CNT" represents "carbon nanotubes"; "PP" represents "polypropylene"; "PE" represents "polyethylene"; "SEBS" represents "hydrogenated styrene-based thermoplastic elastomer"; and "PI" represents "polyimide".

The electromagnetic wave absorbing thermally conductive materials of Examples 1 to 8 contained a thermoplastic resin, a high-magnetic-permeability metal, and carbon nanotubes. Therefore, the electromagnetic wave absorbing thermally conductive materials of Examples 1 to 8 had a shielding performance of more than 25 dB at 100 kHz (acceptable range: 20 dB or more), a shielding performance of more than 80 dB at 10 MHz (acceptable range: 70 dB or more, and a shielding performance of 44 dB or more at 1 GHz (acceptable range: 40 dB or more). The electromagnetic wave absorbing thermally conductive materials of Examples 1 to 8 also had a shielding performance of 99.7% at 76 GHz (acceptable range: 90% or more), a reflection performance of 40% or less at 76 GHz (acceptable range: 50% or less), and an absorption performance of 60% or more at 76 GHz (acceptable range: 50% or more). The layers of the electromagnetic wave absorbing thermally conductive materials of Examples 1 to 8 each had a thermal conductivity of 0.3 W/m$^2$ or more (acceptable range: 0.3 W/m$^2$ or more).

From these results, the electromagnetic wave absorbing thermally conductive materials of Examples 1 to 8 were found to not only shield electromagnetic waves in a low-frequency band and absorb electromagnetic waves in a high-frequency band but also have a favorable thermal conductivity.

On the other hand, the electromagnetic wave absorbing thermally conductive materials of Comparative Examples 1, 9, and 10 contained a thermoplastic resin but neither a high-magnetic-permeability metal nor carbon nanotubes. Therefore, the electromagnetic wave absorbing thermally conductive materials of Comparative Examples 1, 9, and 10 had a shielding performance of 4 dB or less at 100 kHz (acceptable range: 20 dB or more), a shielding performance of 5 dB or less at 10 MHz (acceptable range: 70 dB or more, and a shielding performance of 4 dB or less at 1 GHz (acceptable range: 40 dB or more).

The electromagnetic wave absorbing thermally conductive materials of Comparative Examples 2 to 4 and 6 contained a thermoplastic resin and carbon nanotubes but not a high-magnetic-permeability metal. Therefore, the electromagnetic wave absorbing thermally conductive materials of Comparative Examples 2 to 4 and 6 had a shielding performance of 65 dB or less at 10 MHz (acceptable range: 70 dB or more) and a shielding performance of 37 dB or less at 1 GHz (acceptable range: 40 dB or more).

The electromagnetic wave absorbing thermally conductive materials of Comparative Examples 5 and 7 contained a high-magnetic-permeability metal but neither a thermoplastic resin nor carbon nanotubes. Therefore, the electromagnetic wave absorbing thermally conductive materials of Comparative Examples 5 and 7 had a reflection performance of 99% or more at 76 GHz (acceptable range: 50% or less) and an absorption performance of 0.7% at 76 GHz (acceptable range: 50% or more).

The electromagnetic wave absorbing thermally conductive materials of Comparative Example 8 contained a thermoplastic resin and a high-magnetic-permeability metal but not carbon nanotubes. Therefore, the electromagnetic wave absorbing thermally conductive material of Comparative Example 8 had a reflection performance of 90% at 76 GHz (acceptable range: 50% or less) and an absorption performance of 9% at 76 GHz (acceptable range: 50% or more).

From these results, it was found that the electromagnetic wave absorbing thermally conductive materials of Comparative Examples 1 to 10 were not those which not only shield electromagnetic waves in a low-frequency band and absorb electromagnetic waves in a high-frequency band but also have a favorable thermal conductivity.

The disclosure of Japanese Patent Application No. 2021-028952 filed on February 25, 2021, is hereby incorporated by reference in its entirety.

All the documents, patent applications, and technical standards that are described in the present specification are hereby incorporated by reference to the same extent as if each individual document, patent application, or technical standard is concretely and individually described to be incorporated by reference.

**Claims**

1. An electromagnetic wave absorbing thermally conductive material, comprising:

   a thermoplastic resin;
   a high-magnetic-permeability metal; and
   carbon nanotubes.

2. The electromagnetic wave absorbing thermally conductive material according to claim 1, wherein the high-magnetic-permeability metal comprises a nanocrystalline soft magnetic alloy.

3. The electromagnetic wave absorbing thermally conductive material according to claim 2, wherein the nanocrystalline soft magnetic alloy comprises an FeBSi-based nanocrystalline soft magnetic alloy comprising Fe, B, and Si.

4. The electromagnetic wave absorbing thermally conductive material according to claim 1, wherein the high-magnetic-permeability metal comprises at least one of an FeNi-based soft magnetic alloy comprising Fe and Ni, or an FeBSi-based nanocrystalline soft magnetic alloy comprising Fe, B, and Si.

5. The electromagnetic wave absorbing thermally conductive material according to any one of claims 1 to 4, wherein the thermoplastic resin comprises at least one selected from the group consisting of polypropylenes, polyethylenes, polyesters, and polyamides.

6. The electromagnetic wave absorbing thermally conductive material according to any one of claims 1 to 5, wherein the carbon nanotubes comprise at least one of multi-walled carbon nanotubes or single-walled carbon nanotubes.

7. The electromagnetic wave absorbing thermally conductive material according to any one of claims 1 to 6, further comprising a carbon material.

8. The electromagnetic wave absorbing thermally conductive material according to any one of claims 1 to 7, comprising:

   a magnetic loss layer comprising the high-magnetic-permeability metal; and
   a dielectric loss layer laminated on at least one main surface of the magnetic loss layer,
   wherein the dielectric loss layer comprises the thermoplastic resin and the carbon nanotubes.

9. The electromagnetic wave absorbing thermally conductive material according to claim 8, wherein the dielectric loss layer has a thickness of from 0.01 mm to 30 mm.

10. The electromagnetic wave absorbing thermally conductive material according to claim 8 or 9, wherein a content of the carbon nanotubes is from 0.5% by mass to 30% by mass with respect to a total amount of the dielectric loss layer.

11. The electromagnetic wave absorbing thermally conductive material according to any one of claims 1 to 10, which is a sheet-like product.

12. The electromagnetic wave absorbing thermally conductive material according to any one of claims 1 to 11, which is used for absorbing electromagnetic waves leaking from a contactless power supply apparatus that performs contactless power supply.

13. An electromagnetic wave absorbing thermally conductive housing, comprising:

   a housing of an electronic device, an electronic control unit, an unmanned aerial vehicle, or a lithium secondary battery; and
   the electromagnetic wave absorbing thermally conductive material according to claim 11, which is attached to an inside of the housing.

14. An electromagnetic wave absorbing thermally conductive housing obtained by molding the electromagnetic wave absorbing thermally conductive material according to any one of claims 1 to 7,
   wherein the electromagnetic wave absorbing thermally conductive housing is used for housing an electronic device, an electronic control unit, an unmanned aerial vehicle, or a lithium secondary battery.

## INTERNATIONAL SEARCH REPORT

| International application No. |
|---|
| **PCT/JP2022/007255** |

**A. CLASSIFICATION OF SUBJECT MATTER**

*C08K 7/00*(2006.01)i; *C08L 23/12*(2006.01)i; *C08L 77/00*(2006.01)i; *C08L 101/00*(2006.01)i; *C09K 5/14*(2006.01)i; *C08K 3/08*(2006.01)i
FI: C09K5/14 E; C08L101/00; C08K7/00; C08K3/08; C08L23/12; C08L77/00

According to International Patent Classification (IPC) or to both national classification and IPC

**B. FIELDS SEARCHED**

Minimum documentation searched (classification system followed by classification symbols)
C09K5/00-5/20; H01F1/12-1/38; H01F1/44; H05K9/00; C08K3/00-13/08; C08L1/00-101/14

Documentation searched other than minimum documentation to the extent that such documents are included in the fields searched
Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2005-251918 A (SHIN ETSU POLYMER CO LTD) 15 September 2005 (2005-09-15) claims 1-11, paragraphs [0001], [0010]-[0038] | 1-14 |
| Y | JP 2010-155993 A (CHEIL INDUSTRIES INC) 15 July 2010 (2010-07-15) claims 1-18, paragraphs [0001]-[0044], examples 1-6 | 1-7, 11-14 |
| A | | 8-10 |
| Y | JP 2020-178118 A (TOYO INK SC HOLDINGS CO LTD) 29 October 2020 (2020-10-29) claims 1, 4, paragraphs [0001]-[0002] | 1-14 |
| Y | JP 2018-507322 A (METGLAS, INC) 15 March 2018 (2018-03-15) claims 1-29, paragraphs [0001]-[0002], examples 1, 3, 4 | 1-14 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **31 March 2022** | **12 April 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2022/007255**

| Patent document cited in search report | | | Publication date (day/month/year) | Patent family member(s) | | | Publication date (day/month/year) |
|---|---|---|---|---|---|---|---|
| JP | 2005-251918 | A | 15 September 2005 | US | 2006/0083948 | A1 | |
| | | | | claims 1-44, paragraphs [0001], [0101]-[0254] | | | |
| | | | | WO | 2004/086837 | A1 | |
| | | | | TW | 200425830 | A | |
| JP | 2010-155993 | A | 15 July 2010 | US | 2010/0163795 | A1 | |
| | | | | claims 1-18, paragraphs [0002]-[0045], examples 1-6 | | | |
| | | | | EP | 2204403 | A1 | |
| | | | | CN | 101768367 | A | |
| | | | | KR | 10-2010-0080419 | A | |
| | | | | TW | 201024352 | A | |
| JP | 2020-178118 | A | 29 October 2020 | (Family: none) | | | |
| JP | 2018-507322 | A | 15 March 2018 | WO | 2016/112010 | A1 | |
| | | | | claims 1-29, paragraphs [0001]-[0002], examples 1, 3, 4 | | | |
| | | | | US | 2016/0196907 | A1 | |
| | | | | EP | 3242961 | A1 | |
| | | | | TW | 201631178 | A | |
| | | | | KR | 10-2017-0102938 | A | |
| | | | | CN | 107532267 | A | |
| | | | | HK | 1245354 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019143149 A
- WO 2014157526 A
- JP 2021028952 A